# EUROPEAN PATENT APPLICATION

(11) **EP 4 346 344 A1**
(43) Date of publication of application: **03.04.2024**
(21) Application number: 23197396.7
(22) Date of filing: 14.09.2023
(51) Int. Cl.: H05K 5/06, G09F 9/33

(54) **LED DISPLAY DEVICE**

(30) Priority: 15.09.2022 CN 202211130686
(71) Applicant: Shenzhen Leyard Opto-Electronic Co., Ltd., Shenzhen Guangdong 518110 (CN)
(72) Inventor: GONG, Jie, Shenzhen Guangdong, 518110 (CN); SUN, Xuechao, Shenzhen Guangdong, 518110 (CN); LIU, Ming, Shenzhen Guangdong, 518110 (CN)
(74) Representative: V.O.

(57) **Abstract**

The present invention provides an LED display device. The LED display device includes: a box provided with a first wire hole; a display module connected to the box and spaced apart from the box by a gap, and provided with a second wire hole; a first water-retaining structure including an outer water-retaining surrounding plate encircling a circumferential outer side of the first wire hole, a first drainage channel being provided between the outer water-retaining surrounding plate and the box or the display module; and a second water-retaining structure including a first mounting chamber and an inner water-retaining surrounding plate, the inner water-retaining surrounding plate extending into the first mounting chamber, the inner water-retaining surrounding plate being located on the circumferential outer side of the first wire hole and on a circumferential inner side of the outer water-retaining surrounding plate, the inner water-retaining surrounding plate being provided with a water-retaining frame on an outer wall, and the outer wall of the inner water-retaining surrounding plate being spaced apart from a side wall of the water-retaining surrounding plate frame by a second drainage channel. The technical solution of the present invention effectively solves the problem that the display module deviates from the original installation position on the box under the action of the rebound force of the seal in the related art.

## Description

### Cross Reference to Related Applications

The present disclosure claims benefit of Chinese Patent Application No. 202211130686.7, filed on September 15, 2022, entitled "LED Display Device ", the contents of which are hereby incorporated by reference in its entirety.

### Technical Field

The present invention relates to a technical field of LED display, in particular to an LED display device.

### Background

LED display device is a kind of flat panel display, which is a device for displaying text, image, video, video signal and other information. The LED display device includes a box and a display module. The display module is disposed on a front side of the box.

The water-retaining sealing structure in the related technology is a seal, which is disposed on the front side of the box and abuts against the rear side of the display module. Since the seal in the related technology is sealed by a method that the compression volume (i.e., a reduction in size due to compression in the direction of compression) is generated by extrusion. The greater the squeezing force of the seal, the greater the compression volume, the better the sealing effect. In order to achieve better sealing effect, the seal disposed between the display module and the box needs to be subjected to a larger squeezing pressure. Since there is a rebound force on the seal, and the greater the squeezing force on the seal, the greater the rebound force generated, so that under the premise of achieving water-retaining sealing, there is a greater force between the display module and the box to fix the display module on the box.

However, the rebound force of the seal causes the display module to deviate from the original installation position on the box, making the display module display screen abnormal or water into the box.

### Summary

The main purpose of the present invention is to provide an LED display device to solve the problem that the display module deviates from the original installation position on the box under the action of the rebound force of the seal in the related technology.

In order to achieve the above purpose, the present invention provides an LED display device. The LED display device includes a box provided with a first wire hole; a display module connected to the box and is spaced apart from the box by a gap, and provided with a second wire hole corresponding to the first wire hole; a first water-retaining structure including an outer water-retaining surrounding plate disposed between the box and the display module, wherein the outer water-retaining surrounding plate encloses a circumferential outer side of the first wire hole, and the outer water-retaining surrounding plate being spaced apart from the box or display module by a first distance to form a first drainage channel; and a second water-retaining structure including a first mounting chamber and an inner water-retaining surrounding plate, one of the first mounting chamber and the inner water-retaining surrounding plate being disposed on the box, the other of the first mounting chamber and the inner water-retaining surrounding plate being disposed on the display module, the inner water-retaining surrounding plate extending into the first mounting chamber, the inner water-retaining surrounding plate being located on the circumferential outer side of the first wire hole and on a circumferential inner side of the outer water-retaining surrounding plate, an outer wall of the inner water-retaining surrounding plate being provided with a water-retaining frame, and a second drainage channel communicated with the first drainage channel being formed between the outer wall of the inner water-retaining surrounding plate and a side wall of the water-retaining frame.

In some embodiments, the first mounting chamber is disposed on the display module, the inner water-retaining surrounding plate is disposed on the box, the outer water-retaining surrounding plate is spaced apart from the box by the first distance, a water-retaining cylinder sheathed on the inner water-retaining surrounding plate is disposed at a circumferential outer edge of the water-retaining frame, and a mouth of the water-retaining cylinder faces the box.

In some embodiments, a connecting frame is provided at an end of the inner water-retaining surrounding plate away from the display module, the connecting frame is connected to a front surface of the box, and an interior of the connecting frame corresponds to the first wire hole.

In some embodiments, a second mounting chamber communicated with the first wire hole is disposed on the front surface of the box, the connecting frame is fitted in the second mounting chamber, and a waterproof adhesive layer is disposed between a circumferential outer side of the connecting frame and a chamber wall of the second mounting chamber.

In some embodiments, the LED display device further includes a seal located in the first mounting chamber, the seal being sleeved on a circumferential outer side of the inner water-retaining surrounding plate and located in the circumferential inner side of the outer water-retaining surrounding plate, a part of the seal extending into the gap, and a third drainage channel communicating the first drainage channel and the second drainage channel being formed between the seal and the box; and the seal having a hardness less than a hardness of the water-retaining frame.

In some embodiments, an end of the inner water-retaining surrounding plate away from the box is provided with a water-retaining flange extending in a circle along a circumferential direction of the inner water-retaining surrounding plate, the water-retaining flange is spaced apart from the inner side wall of the seal by a second distance, and the water-retaining flange, part of the outer wall of the inner water-retaining surrounding plate and the water-retaining frame enclose a fourth drainage channel communicated with the second drainage channel.

In some embodiments, the seal includes a sealing ring portion connected to a rear surface of the display module and a water-retaining ring portion arranged at an end of the sealing ring portion facing the box, an inner hole of the sealing ring portion corresponds to the second wire hole, a part of the water-retaining ring portion extends into the gap, and an inner part of the water-retaining ring portion shields a circumferential outer edge of the water-retaining frame.

In some embodiments, the first mounting chamber is communicated with the second wire hole, the sealing ring portion is fitted in the first mounting chamber, and the sealing ring portion includes an annular plate spaced from the water-retaining ring portion and a connecting surrounding plate for connecting the annular plate and the water-retaining ring portion.

In some embodiments, the LED display device further includes a bracket supported in the sealing ring portion, the bracket being fixed to the rear surface of the display module to sandwich the sealing ring portion between the bracket and the rear surface of the display module.

In some embodiments, the outer water-retaining surrounding plate is disposed on the rear surface of the display module, the first water-retaining structure further includes a water-retaining groove disposed on the front surface of the box and corresponding to the outer water-retaining surrounding plate, the outer water-retaining surrounding plate extends into the water-retaining groove, and the first drainage channel is formed between the outer water-retaining surrounding plate and a wall of the water-retaining groove on the box.

In some embodiments, the box includes a frame and a power box connected in the frame, the first wire hole is disposed on the power box, a circuit board is arranged in the power box, the circuit board is connected with a first connector, and the first wire hole avoids the first connector; and the display module includes a lamp panel module and a rear cover arranged at a rear side of the lamp panel module, the rear cover is installed on a front side of the frame through a magnetic attraction structure, the second wire hole is disposed on the rear cover, the lamp panel module is provided with a second connector being plugged and mated with the first connector, and the second wire hole avoids the second connector.

By applying the technical solution of the present invention, the LED display device includes a box, a display module, a first water-retaining structure and a second water-retaining structure. The box is provided with a first wire hole. The display module is connected to the box and is spaced apart from the box by a gap. The display module is provided with a second wire hole corresponding to the first wire hole. In this way, the components in the box can be connected to the display module through the first wire hole and the second wire hole for electrification and signal communication. The first water-retaining structure includes an outer water-retaining surrounding plate which is arranged between the box and the display module. The outer water-retaining surrounding plate is arranged around the circumferential outer side of the first wire hole, and a first distance is provided between the outer water-retaining surrounding plate and the box or the display module to form a first drainage channel. The water entering into the gap between the display module and the box from the outside of the LED display device is blocked by the outer water-retaining surrounding plate, so that most of the water is discharged along the circumferential direction of the outer water-retaining surrounding plate, and only a small part of the water flows out from the first drainage channel. The second water-retaining structure includes a first mounting chamber and an inner water-retaining surrounding plate. The first mounting chamber is provided to facilitate the installation of the second water-retaining structure. One of the first mounting chamber and the inner water-retaining surrounding plate is disposed on the box, and the other of the first mounting chamber and the inner water-retaining surrounding plate is disposed on the display module. The inner water-retaining surrounding plate extends into the first mounting chamber, and the inner water-retaining surrounding plate is located on the circumferential outer side of the first wire hole and on the circumferential inner side of the outer water-retaining surrounding plate. In this way, a small part of water is blocked by the inner water-retaining surrounding plate and flows to the outer wall of the inner water-retaining surrounding plate, so that it cannot directly enter the first wire hole. A water-retaining frame is disposed on the outer wall of the inner water-retaining surrounding plate, and a second drainage channel communicated with the first drainage channel is formed between the outer wall of the inner water-retaining surrounding plate and the side wall of the water-retaining frame. A small part of the water flow passes through the first water-retaining structure and then flows to the outer wall of the inner water-retaining surrounding plate through the first drainage channel, due to the existence of the water-retaining frame on the outer wall of the inner water-retaining surrounding plate, water cannot pass over the water-retaining frame to be discharged from the second drainage channel, that is, water cannot enter the first wire hole and the second wire hole, thereby achieving the function of water-retaining seal. At the same time, because of the gap, the first distance, the first drainage channel and the second drainage channel between the box and the display module, so that the box and the display module are only in contact at joints, and there is no contact at other positions, so that the force between the display module and the box is only used to fix the display module on the box, no additional acting force is needed to be generated between the display module and the box. Unlike the related technology in which the seal generates a large rebound force that makes the display module and the box have a large force between them, the present invention can avoid the problem that the display module deviates from the original installation position on the box under the action of the rebound force of the seal, so that problems that the display screen of the display module is abnormal or water easily enters the box body can be solved. Therefore, the technical solution of the present application effectively solves the problem that the display module deviates from the original installation position on the box under the action of the rebound force of the seal in the related technology.

### Brief Description of the Drawings

The accompanying drawings, forming part of the present application, serve to provide a further understanding for the present invention, and the exemplary embodiments of the present invention as well as the illustrations thereof serve to explain the present invention and do not constitute an undue limitation of the present invention. In the drawings:
FIG. 1 shows a stereoscopic structural schematic diagram of an embodiment of an LED display device according to the present invention;
FIG. 2 shows a front view of the LED display device of FIG. 1;
FIG. 3 shows an A-A sectional view of the LED display device of FIG. 2;
FIG. 4 shows a partially enlarged view at part C of the LED display device of FIG. 3;
FIG. 5 shows a B-B sectional view of the LED display device of FIG. 2;
FIG. 6 is a schematic diagram showing a flow direction of water outside the LED display device of FIG. 1 after entering the LED display device;
FIG. 7 shows a cross-sectional view of the LED display device of FIG. 1 when a display module is not mounted to a box;
FIG. 8 shows a partially enlarged view at part D of the LED display device of FIG. 7;
FIG. 9 shows a stereoscopic structural schematic diagram of a rear cover of the LED display device of FIG. 1;
FIG. 10 shows a decomposed schematic diagram of a rear cover of the LED display device of FIG. 9;
FIG. 11 shows a front view of the rear cover of the LED display device of FIG. 9;
FIG. 12 shows an E-E sectional view of the rear cover of the LED display device of FIG. 11;
FIG. 13 shows a stereoscopic structural schematic diagram of a second water-retaining structure of the LED display device of FIG. 1;
FIG. 14 shows a stereoscopic structural schematic diagram of a seal of the LED display device of FIG. 1; and
FIG. 15 shows a stereoscopic structural schematic diagram of a bracket of the LED display device of FIG. 1;

The above drawings include the following reference signs:
10: box; 11: frame; 12: power box; 13: first wire hole;
20: display module; 21: lamp panel module; 22: rear cover; 23: second wire hole;
30: first water-retaining structure; 31: outer water-retaining surrounding plate; 32: water-retaining groove;
40: second water-retaining structure; 41: inner water-retaining surrounding plate; 42: water-retaining frame; 43: water-retaining cylinder; 44: connecting frame; 45: water-retaining flange;
50: bracket; 60: seal; 61: sealing ring portion; 611: connecting surrounding plate; 612: annular plate; 62: water-retaining ring portion;
71: waterproof adhesive layer; 72: magnetic attraction structure;
81: first mounting chamber; 82: second mounting chamber;
91: first drainage channel; 92: second drainage channel; 93: third drainage channel; 94: fourth drainage channel.

### Detailed Description of the Embodiments

A clear and complete description of the technical solution in the embodiments of the present invention will be made below in conjunction with the accompany drawings in the embodiments of the present invention. Obviously, the described embodiments are only part of the embodiments of the present invention, but not all of them. The following description of at least one exemplary embodiment is in fact merely illustrative and is in no way intended to limit the present invention and its application or use. Based on the embodiments of the present invention, all other embodiments obtained by those ordinarily skilled person in the art, without exerting creative effort, fall within the scope of protection of the present invention.

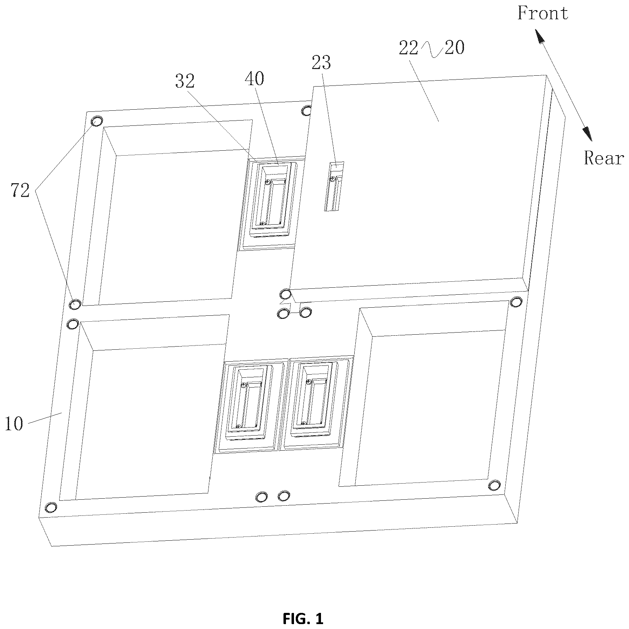

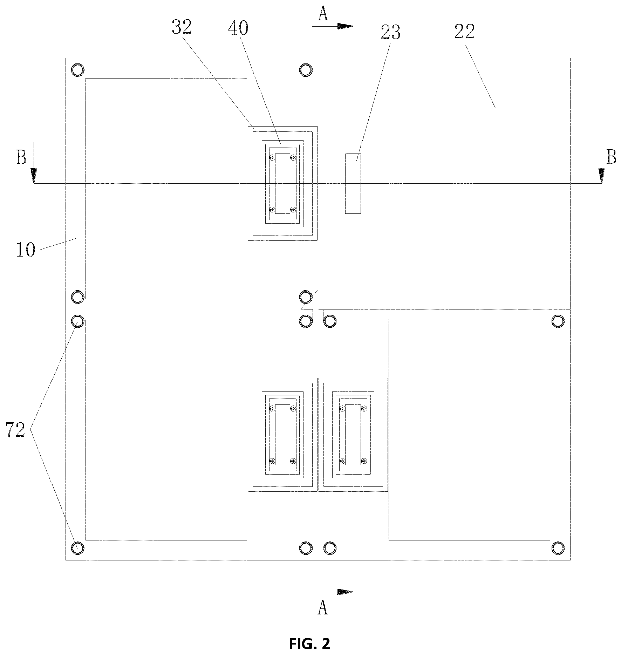

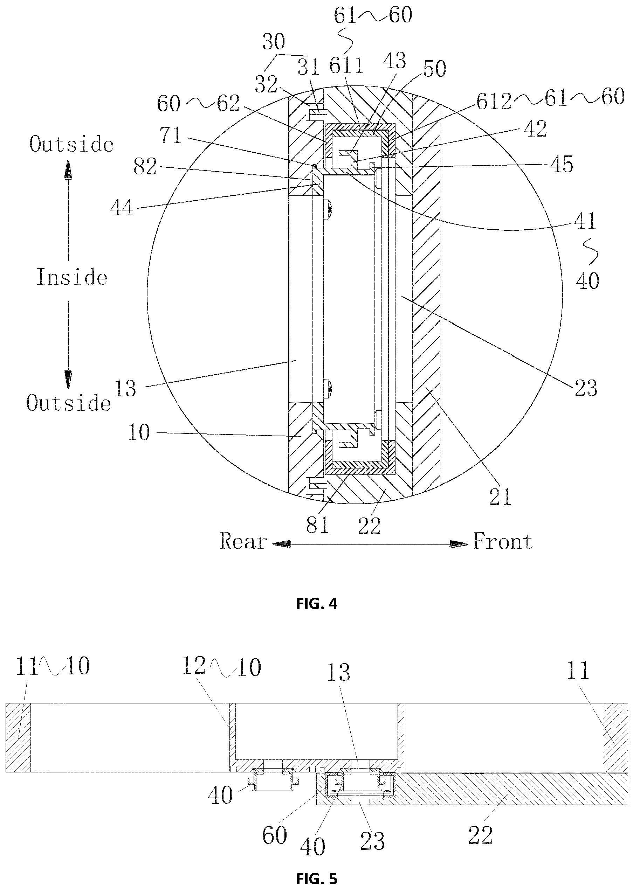

As shown in FIGS. 1 to 6, the LED display device of the present embodiment includes a box 10, a display module 20, a first water-retaining structure 30, and a second water- retaining structure 40. The box 10 is provided with a first wire hole 13. The display module 20 is connected to the box 10 and is spaced apart from the box 10 by a gap. The display module 20 is provided with a second wire hole 23 corresponding to the first wire hole 13. The first water-retaining structure 30 includes an outer water-retaining surrounding plate 31. The outer water-retaining surrounding plate 31 is disposed between the box 10 and the display module 20. The outer water-retaining surrounding plate 31 encloses a circumferential outer side of the first wire hole 13, and a first distance is provided between the outer water-retaining surrounding plate 31 and the box 10 or the display module 20 to form a first drainage channel 91. The second water-retaining structure 40 includes a first mounting chamber 81 and an inner water-retaining surrounding plate 41. One of the first mounting chamber 81 and the inner water-retaining surrounding plate 41 is disposed on the box 10, and the other of the first mounting chamber 81 and the inner water-retaining surrounding plate 41 is disposed on the display module 20. The inner water-retaining surrounding plate 41 extends into the first mounting chamber 81, and the inner water-retaining surrounding plate 41 is located on the circumferential outer side of the first wire hole 13 and on the circumferential inner side of the outer water-retaining surrounding plate 31. A water-retaining frame 42 is disposed on the outer wall of the inner water-retaining surrounding plate 41, and a second drainage channel 92 communicated with the first drainage channel 91 is formed between the outer wall of the inner water-retaining surrounding plate 41 and the side wall of the water-retaining frame 42.

In application to the technical solution to this embodiment, the LED display device includes the box 10, the display module 20, the first water-retaining structure 30 and the second water-retaining structure 40. The box 10 is provided with a first wire hole 13. The display module 20 is connected to the box 10 and is spaced apart from the box 10 by a gap. The display module 20 is provided with a second wire hole 23 corresponding to the first wire hole 13. In this way, the components in the box 10 can be connected to the display module 20 through the first wire hole 13 and the second wire hole 23 for electrification and signal communication. The first water-retaining structure 30 includes an outer water-retaining surrounding plate 31. The outer water-retaining surrounding plate 31 is disposed between the box 10 and the display module 20. The outer water-retaining surrounding plate 31 encloses a circumferential outer side of the first wire hole 13, and a first distance is provided between the outer water-retaining 31 surrounding plate and the box 10 or the display module 20 to form a first drainage channel 91. The water entering into the gap between the display module 20 and the box 10 from the outside of the LED display device is blocked by the outer water-retaining surrounding plate 31, so that most of the water is discharged along the circumferential direction of the outer water-retaining surrounding plate 31, and only a small part of the water flows out from the first drainage channel 91. The second water-retaining structure 40 includes a first mounting chamber 81 and an inner water-retaining surrounding plate 41. The first mounting chamber 81 is provided to facilitate the installation of the second water-retaining structure 40. One of the first mounting chamber 81 and the inner water-retaining surrounding plate 41 is disposed on the box 10, and the other of the first mounting chamber 81 and the inner water-retaining surrounding plate 41 is disposed on the display module 20. The inner water-retaining surrounding plate 41 extends into the first mounting chamber 81, and the inner water-retaining surrounding plate 41 is located on the circumferential outer side of the first wire hole 13 and on the circumferential inner side of the outer water-retaining surrounding plate 31. In this way, a small part of water is blocked by the inner water-retaining surrounding plate 41 and flows to the outer wall of the inner water-retaining surrounding plate 41, so that it cannot directly enter the first wire hole 13. A water-retaining frame 42 is disposed on the outer wall of the inner water-retaining surrounding plate 41, and a second drainage channel 92 communicated with the first drainage channel 91 is formed between the outer wall of the inner water-retaining surrounding plate 41 and the side wall of the water-retaining frame 42. A small part of the water flow passes through the first water-retaining structure 30 and then flows to the outer wall of the inner water-retaining surrounding plate 41 through the first drainage channel 91, due to the existence of the water-retaining frame 42 on the outer wall of the inner water-retaining surrounding plate 41, water cannot pass over the water-retaining frame 42 to be discharged from the second drainage channel 92, that is, water cannot enter the first wire hole 13 and the second wire hole 23, thereby achieving the function of water-retaining seal. At the same time, because of the gap, the first distance, the first drainage channel 91 and the second drainage channel 92 between the box 10 and the display module 20, so that the box 10 and the display module 20 are only in contact at joints, and there is no contact at other positions, so that the force between the display module 20 and the box 10 is only used to fix the display module 20 on the box 10, no additional acting force is needed to be generated between the display module 20 and the box 10. Unlike the related technology in which the seal 60 generates a large rebound force that makes the display module 20 and the box 10 have a large force between them, the present invention can avoid the problem that the display module 20 deviates from the original installation position on the box 10 under the action of the rebound force of the seal 60, so that problems that the display screen of the display module 20 is abnormal or water easily enters the box 10 can be solved. Therefore, the technical solution of this embodiment effectively solves the problem that the display module deviates from the original installation position on the box under the action of the rebound force of the seal in the related technology.

It should be noted that the box 10 and the LED display device are perpendicular to the ground when in use, and the water flows from top to bottom due to its own gravity. Therefore, water outside the LED display device cannot enter the box 10 from a lower part, thereby avoiding backflow.

As shown in FIGS. 1 to 6, the first mounting chamber 81 is provided on the display module 20, and the inner water-retaining surrounding plate 41 is provided on the box 10. There is a first distance between the outer water-retaining surrounding plate 31 and the box 10. The inner water-retaining surrounding plate 41 blocks a small part of water entering from the outside of the LED display device through the first distance to flow onto the outer wall of the inner water-retaining surrounding plate 41, and since the water-retaining frame 42 is provided on the outer wall of the inner water-retaining surrounding plate 41, water cannot pass over the water-retaining frame 42. A water-retaining cylinder 43 sheathed on the inner water-retaining surrounding plate 41 is disposed at the circumferential outer edge of the water-retaining frame 42, and the mouth of the water-retaining cylinder 43 faces the box 10. The water-retaining cylinder 43 is provided to further prevent water entering from the outside of the LED display device from passing over the water-retaining cylinder 43 and then being discharged from the second drainage channel 92, which further improves the waterproof performance.

As shown in FIGS. 1 to 6, an end of the inner water-retaining surrounding plate 41 away from the display module 20 is provided with a connecting frame 44 connected to the front surface of the box 10. The connecting frame 44 is provided to facilitate the connection between the inner water-retaining surrounding plate 41 and the box 10. In this embodiment, the connecting frame 44 is preferably fixed to the box 10 by screws. The interior of the connecting frame 44 corresponds to the first wire hole 13, so that the connecting frame 44 does not block the first wire hole 13, so that the components in the box 10 can be plugged and mated with the display module 20 through the first wire hole 13 and the connecting frame 44.

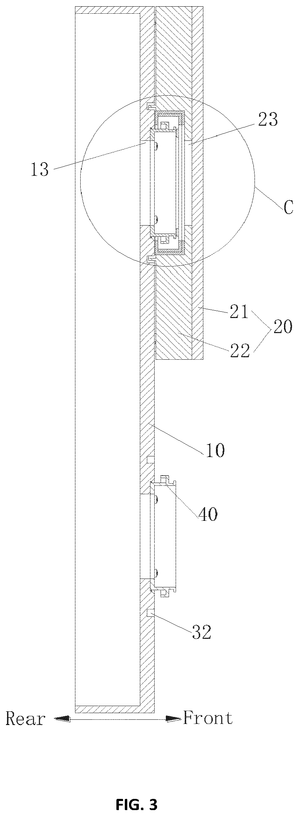

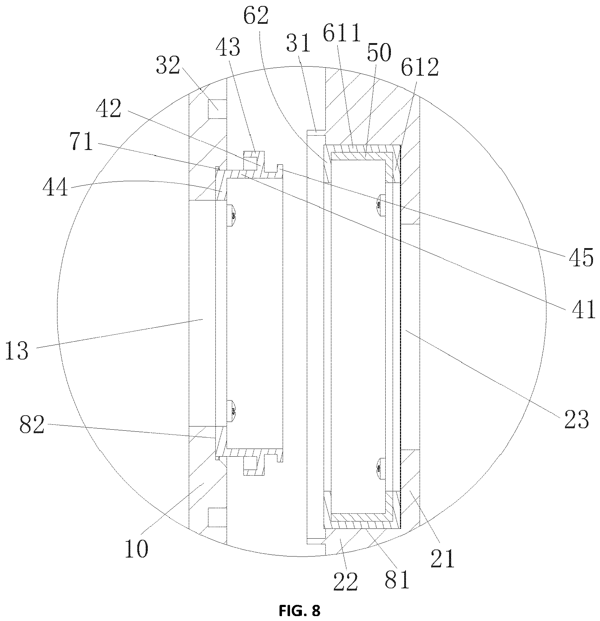

As shown in FIGS. 3 to 8, the front surface of the box 10 is provided with a second mounting chamber 82 which communicates with the first wire hole 13. The connecting frame 44 is fitted in the second mounting chamber 82, and the second mounting chamber 82 provides a space for the arrangement of the connecting frame 44, thus ensuring the connection effect between the connecting frame 44 and the chamber wall of the second mounting chamber 82. A waterproof adhesive layer 71 is provided between the circumferential outer side of the connecting frame 44 and the chamber wall of the second mounting chamber 82. The waterproof adhesive layer 71 can seal the circumferential outer side of the connecting frame 44 and the chamber wall of the second mounting chamber 82, which further prevents water entering from the outside of the LED display device from entering the first wire hole 13 from the joint of the connecting frame 44 and the box 10. In this embodiment, a chamfered portion is provided at the junction of the chamber wall of the second mounting chamber 82 and the front surface of the box 10, and the chamfered portion is provided so that water entering the second drainage channel 92 can be quickly discharged.

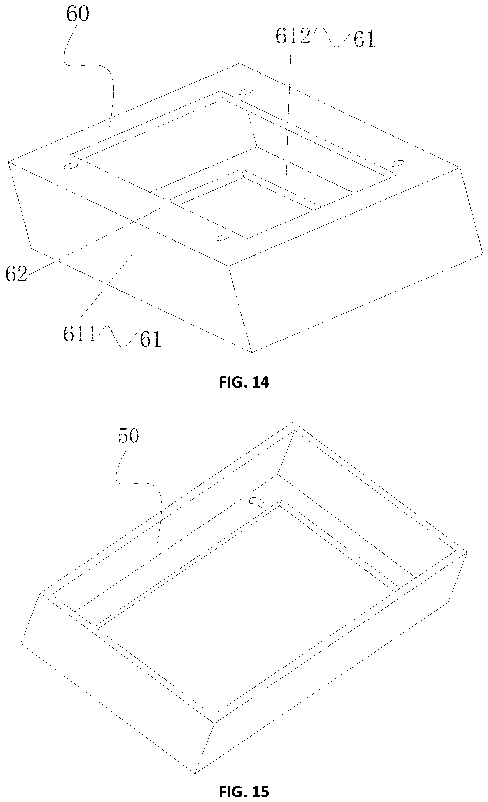

As shown in FIGS. 3 to 8 and FIG. 14, the LED display device further includes a seal 60 located within the first mounting chamber 81. The seal 60 is sleeved on the outer circumferential side of the inner water-retaining surrounding plate 41 and on the inner circumferential side of the outer water-retaining surrounding plate 31. The seal 60 blocks a small part of water flowing in from the outside of the LED display device through the first drainage channel 91, so that it is difficult for the water to enter the first mounting chamber 81. A part of the seal 60 extends into the gap, and a third drainage channel 93 communicating the first drainage channel 91 and the second drainage channel 92 is formed between the seal 60 and the box 10. Thus, in a plane cut along the axis of the first wire hole 13, a width of the third drainage channel 93 is smaller than that of the first drainage channel 91, so that a part of the water flowing out of the first drainage channel 91 is again discharged in the circumferential direction of the outer wall of the outer water-retaining surrounding plate 31, thereby reducing the amount of water flowing through the third drainage channel 93 and thus the amount of water flowing into the second drainage channel 92.

Further, the hardness of the seal 60 is smaller than the hardness of the water-retaining frame 42. In this embodiment, the seal 60 is preferably made of silica gel, and the water-retaining frame 42 is preferably made of plastic or metal. The seal 60 is fixed to the display module 20, and the water-retaining frame 42 is fixed to the box 10 through the inner water-retaining surrounding plate 41 and the connecting frame 44. Since the seal 60 is made of silica gel, it has good elasticity, can be deformed and can be restored to the original shape. When the display module 20 is mounted to the box 10, one end of the seal 60 facing the box 10 abuts against the front surface of the water-retaining frame 42, and a backward force is applied to the display module 20, so that the seal 60 is deformed toward one end of the box 10 to pass over the water-retaining frame 42, and the seal 60 is restored to its original shape under its own elastic force.

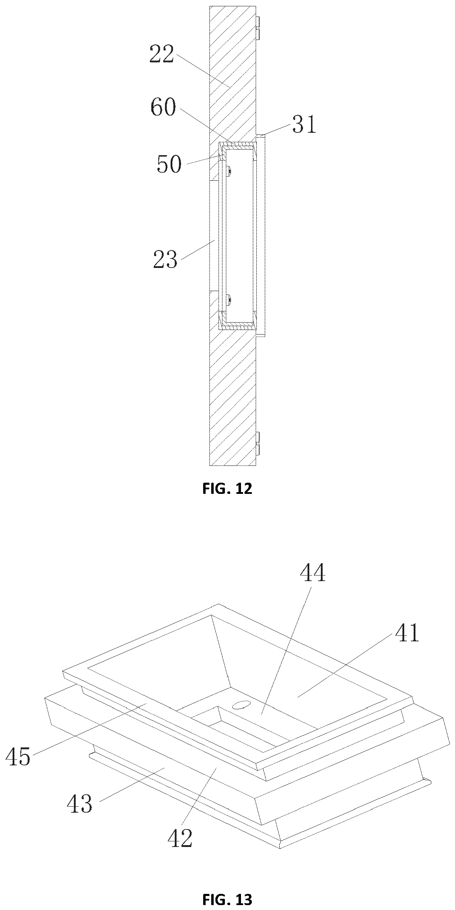

As shown in FIG. 3 to FIG. 8 and FIG. 13, an end of the inner water-retaining surrounding plate 41 away from the box 10 is provided with a water-retaining flange 45. In this embodiment, the water-retaining flange 45 extends in a circle along the circumferential direction of the inner water-retaining surrounding plate 41. There is a second space between the water-retaining flange 45 and the inner side wall of the seal 60. The water-retaining flange 45, a part of the outer wall of the inner water-retaining surrounding plate 41, and the water-retaining frame 42 enclose a fourth drainage channel 94 which communicates with the second drainage channel 92. The water-retaining flange 45 is provided such that a small amount of water entering into the fourth water-drainage channel 94 from the second water-drainage channel 92 through the second distance can be discharged in the circumferential direction of the outer wall of the inner water-retaining surrounding plate 41. The first drainage channel 91, the second drainage channel 92, the third drainage channel 93 and the fourth drainage channel 94 form a labyrinth drainage path, so that the water flow path is complicated and does not flow backwards, thus further improving the waterproof performance, so that the water outside the LED display device cannot enter the box 10 from the first wire hole 13 and the second wire hole 23, thus achieving the function of water-retaining and sealing. At the same time, since the box 10 is spaced apart from the display module 20 by the gap, the first distance, the second distance, the first drainage channel 91, the second drainage channel 92, the third drainage channel 93 and the fourth drainage channel 94, the box 10 and the display module 20 are in contact only at the joint, while there is no contact at other positions. The seal 60 is not subjected to the squeezing force exerted from the box 10, the acting force between the display module 20 and the box 10 is only used for fixing the display module 20 to the box 10 without any other internal stress, and no additional acting force is generated between the display module 20 and the box 10, and the seal 60 is not compressed tightly or is not completely compressed to produce a rebound force. Unlike the related technology in which the seal 60 generates a large rebound force that makes the display module 20 and the box 10 have a large force between them, the present invention can avoid the problem that the display module 20 deviates from the original installation position on the box 10 under the action of the rebound force of the seal 60, so that problems that the display screen of the display module 20 is abnormal or water easily enters the box 10 can be solved.

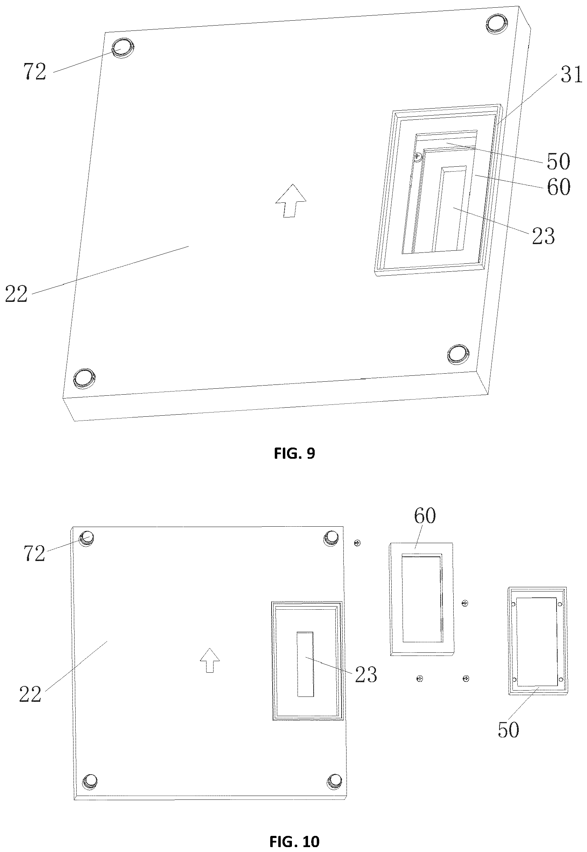

As shown in FIGS. 3 to 10, the seal 60 includes a sealing ring portion 61 connected to the rear surface of the display module 20 and a water-retaining ring portion 62 provided at one end of the sealing ring portion 61 facing the box 10. The sealing ring portion 61 is provided so that water outside the LED display device cannot enter the first wire hole 13 and the second wire hole 23 from the contact of the seal 60 and the display module 20, and thus cannot enter the box 10 and the display module 20. The inner hole of the sealing ring portion 61 corresponds to the second wire hole 23, so that the sealing ring portion 61 does not block the second wire hole 23, the components in the box 10 can pass through the second wire hole 23 and the inner hole of the sealing ring portion 61 to be plugged and mated with the display module 20. A part of the water-retaining ring portion 62 is extended into the gap so that a distance between the rear surface of the water-retaining ring and a front surface of the box 10 is reduced, and the width of the third drainage channel 93 in a plane cut along the axis of the first wire hole 13 is reduced, causing a reduction of the amount of water flowing out of the third drainage channel 93, thus achieving a better water-retaining effect. The inner portion of the water-retaining ring portion 62 shields the circumferential outer edge of the water-retaining frame 42.

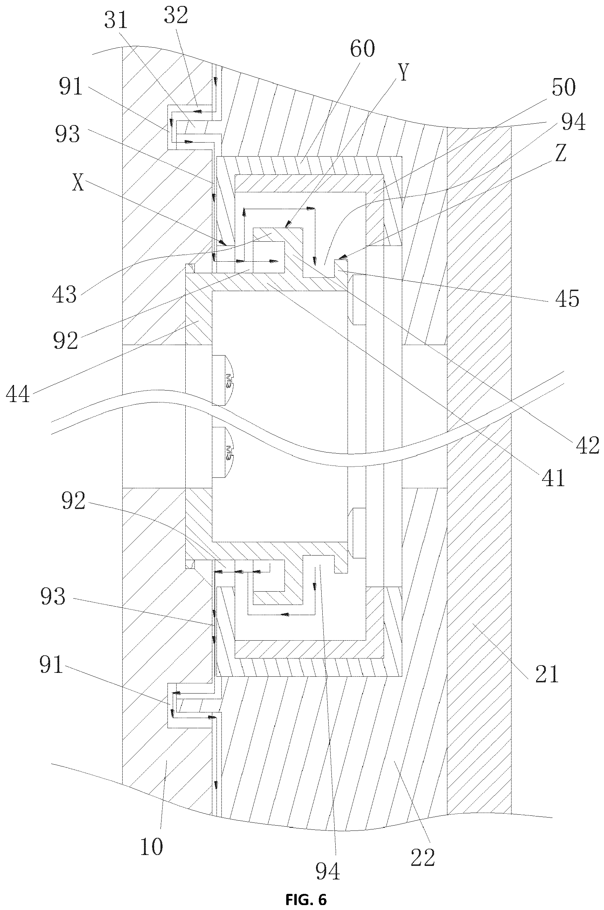

As shown in FIG. 6, in this embodiment, the surface of the inner portion above the water-retaining ring portion 62 is an X-plane, the surface of the circumferential outer edge above the water-retaining frame 42 is a Y-plane, and the surface of the circumferential outer edge above the water-retaining flange 45 is a Z-plane. In the plane cut along the axis of the first wire hole 13, the Y plane is higher than the X plane. When water enters the first drainage channel 91 from the outside of the LED display device, a part of the water is discharged along the circumferential direction of the outer wall of the inner water-retaining surrounding plate 41 due to the arrangement of the outer water-retaining surrounding plate 31. Another part of the water enters the third drainage channel 93, and the water-retaining ring portion 62 partially extends into the gap, blocking a part of the water from passing through the third drainage channel 93, so that the remaining water enters the second drainage channel 92. The X-plane of the water-retaining ring portion 62 is provided so that the water in the second drainage channel 92 is difficult to overflow over the X-plane and a part of the water is discharged in the circumferential direction of the outer wall of the inner water-retaining surrounding plate 41. If water overflows the X-plane, the Y-plane of the water-retaining frame 42 is arranged and the Y-plane is higher than the X-plane, so that the water is difficult to overflow the Y-plane. If a small amount of water overflows the Y-plane, the water cannot overflow the Z-plane due to the arrangement of the water-retaining flange 45. In this way, the waterproof performance is ensured, and the water outside the LED display device cannot enter the box 10 through the first wire hole 13 and the second wire hole 23.

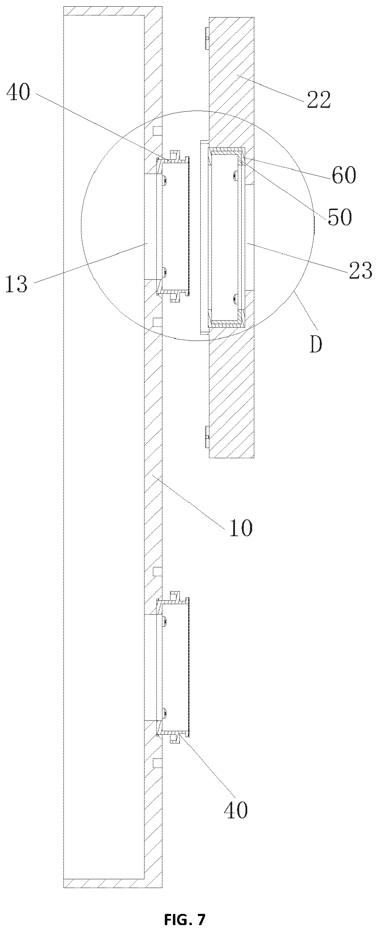

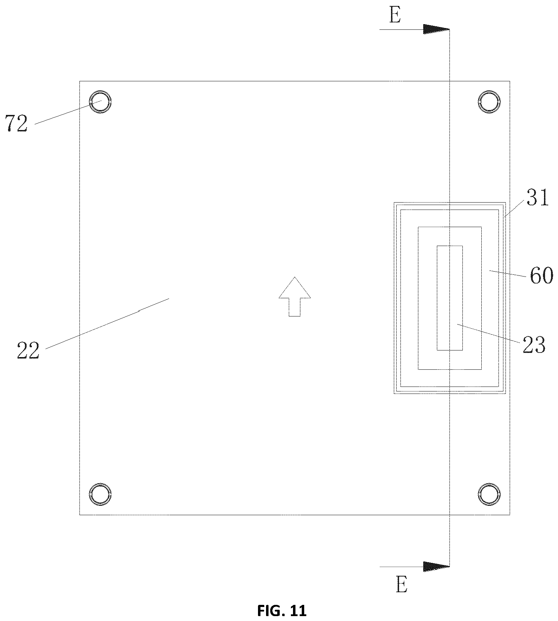

As shown in FIGS. 7 to 12, the first mounting chamber 81 communicates with the second wire hole 23, so that the components in the box 10 can be plugged and mated with the display module 20 through the first mounting chamber 81 and the second wire hole 23. The sealing ring portion 61 is fitted in the first mounting chamber 81 so that the seal 60 and the first mounting chamber 81 have a sufficiently large sealing area to ensure that water outside the LED display device cannot pass through the contact between the sealing ring portion 61 and the display module 20, thereby ensuring a sealing effect. The sealing ring portion 61 includes an annular plate 612 spaced apart from the water-retaining ring portion 62 and a connecting surrounding plate 611 for connecting the annular plate 612 and the water-retaining ring portion 62. The arrangement of the annular plate 612 and the connecting surrounding plate 611 enables the sealing ring portion 61 to be more closely fitted within the first mounting chamber 81, and further prevents water outside the LED display device from entering the contact between the sealing ring portion 61 and the display module 20.

As shown in FIGS. 7 to 12 and FIG. 15, the LED display device further includes a bracket 50 supported in the sealing ring portion 61, the bracket 50 enables the seal 60 to be more firmly fixed to the display module 20, and the bracket 50 also enables the sealing ring portion 61 of the seal 60 to maintain its original shape. The bracket 50 is fixed to the rear surface of the display module 20 to sandwich the sealing ring portion 61 between the bracket 50 and the rear surface of the display module 20, and the bracket 50 is provided so that the sealing ring portion 61 of the seal 60 can be more closely fitted in the first mounting chamber 81.

In this embodiment, the seal 60 has a "U" shaped profile and the bracket 50 has an "L" shaped profile in the plane cut along the axis of the first wire hole 13. The bracket 50 is preferably screwed to the display module 20.

As shown in FIGS. 7 to 12, the outer water-retaining surrounding plate 31 is provided on the rear surface of the display module 20. The first water-retaining structure 30 further includes a water-retaining groove 32 provided on the front surface of the box 10 and corresponding to the outer water-retaining surrounding plate 31. The outer water-retaining surrounding plate 31 extends into the water-retaining groove 32, and the first drainage channel 91 is formed between the outer water-retaining surrounding plate 31 and the wall of the water-retaining groove 32 on the box 10. The first drainage channel 91 formed between the water-retaining groove 32 and the outer water-retaining surrounding plate 31 complicates the path of the water flow. Thus, the impact force of the water flow entering into the gap between the display module 20 and the box 10 from the outside of the LED display device is greatly reduced, and a part of the water entering from the outside of the LED display device is also discharged along the circumferential direction of the outer wall of the inner water-retaining surrounding plate 41, thus reducing the water entering into the third drainage channel 93.

As shown in FIGS. 1 to 5, the box 10 includes a frame 11 and a power box 12 connected in the frame 11, and a first wire hole 13 is provided on the power box 12. A circuit board is arranged in the power box 12, the circuit board is connected with a first connector, and the first wire hole 13 avoids the first connector. Thus, the first connector on the circuit board in the power box 12 can pass through the first wire hole 13.

Further, the display module 20 includes a lamp panel module 21 and a rear cover 22 provided at the rear of the lamp panel module 21. The rear cover 22 is mounted on the front side of the frame 11 through a magnetic attraction structure 72. The magnetic attraction structure 72 includes a first magnet disposed on the rear cover 22 and a second magnet disposed on the frame 11, the first magnet being magnetically engaged with the second magnet. Since the seal 60 in this embodiment is not in contact with the box 10 and does not need to generate a compression amount, there is no contact between the box 10 and the display module 20 except the magnetic attraction structure 72, so that the acting force between the display module 20 and the box 10 is only used to fix the display module 20 on the box 10, so that the need for fixing the display module 20 on the box 10 can be met without additional acting force between the display module 20 and the box 10. The magnetic attraction structure 72 satisfies the required force between the display module 20 and the box 10. Moreover, since the required acting force is small, the requirement for the magnetic attraction structure 72 is reduced, and the requirement for the magnetic force level of the magnets is also reduced, so that the cost is reduced, or the cost can be reduced by using a small number of magnets, that is, only the second magnet that is magnetically matched with the first magnet is provided on the frame 11. Thus, the display module 20 is magnetically fixed to the box 10, so that the display module 20 can be quickly removed and mounted on the box 10.

In this embodiment, there is one box 10, and each of the display modules 20 and the seals 60 are four. The four display modules 20 are spliced on the front side of the box 10 through a magnetic attraction structure 72, and each seal 60 is sealed in a corresponding first mounting chamber 81. Each seal 60 is not in contact with the box 10 and does not need to generate a compression amount, except for the magnetic attraction structure 72, there is no contact between the box 10 and the display module 20, the present invention avoids the problem that the seal 60, like the related technology, requires a large rebound force to achieve sealing, and the seal 60 causes water leakage due to the rebound force pushing the display module 20 away from the box 10 or deviating from the original installation position on the box 10, or causes the display module 20 to bend, resulting in abnormal display screen and generation of bright lines or dark lines between the modules.

In this embodiment, the back cover 22 is preferably a closed waterproof back cover 22, which has a closed structure except for the second wire hole 23.

Further, the second wire hole 23 is provided on the rear cover 22, and a second connector which is plugged and mated with the first connector is provided on the lamp panel module 21, and the second wire hole 23 avoids the second connector. In this way, the second connector on the lamp panel module 21 can pass through the second wire hole 23. The first connector and the second connector are plugged and mated in the first mounting chamber 81. Due to the arrangement of the first water-retaining structure 30, the second water-retaining structure 40 and the seal 60, no water can enter the first mounting chamber 81 when the first connector and the second connector are pluged and mated with each other, thus ensuring the normal operation of the LED display device.

In the description of the present invention, it should be understood that, orientation or positional relationships indicated by orientation words such as "front, back, up, down, left, right", "lateral, vertical, perpendicular, horizontal" and "top, bottom" are generally based on the orientation or positional relationships shown in the drawings, for ease of description of the present invention and simplification of the description only, these orientation words do not indicate or imply that the apparatus or element referred to must have a specific orientation or be constructed and operated in a specific orientation, and therefore cannot be construed as limitations to the scope of the present invention. The orientation words "inside and outside" refer to the inside and outside relative to the outline of each component itself.

In addition, it should be noted that the words "first", "second" and the like are used to define parts only for the purpose of distinguishing the corresponding parts. Unless otherwise stated, the above words have no special meaning and therefore cannot be understood as limitations to the scope of protection of the present invention.

The foregoing is merely a preferred embodiment of the present invention and is not intended to limit the present invention which may be subject to various modifications and variations to those skilled in the art. Any modification, equivalent replacement, improvement, etc. made within the spirit and principles of the present invention should be included in the scope of protection of the present invention.

## Claims

1. A LED display device comprising:
a box (10) provided with a first wire hole (13);
a display module (20) connected to the box (10) and spaced apart from the box (10) by a gap, and provided with a second wire hole (23) corresponding to the first wire hole (13);
a first water-retaining structure (30) comprising an outer water-retaining surrounding plate (31) disposed between the box (10) and the display module (20), wherein the outer water-retaining surrounding plate (31) encloses a circumferential outer side of the first wire hole (13), and the outer water-retaining surrounding plate (31) being spaced apart from the box (10) or the display module (20) by a first distance to form a first drainage channel (91); and
a second water-retaining structure (40) comprising a first mounting chamber (81) and an inner water-retaining surrounding plate (41), one of the first mounting chamber (81) and the inner water-retaining surrounding plate (41) being disposed on the box (10), the other of the first mounting chamber (81) and the inner water-retaining surrounding plate (41) being disposed on the display module (20), the inner water-retaining surrounding plate (41) extending into the first mounting chamber (81), the inner water-retaining surrounding plate (41) being located on the circumferential outer side of the first wire hole (13) and on a circumferential inner side of the outer water-retaining surrounding plate (31), an outer wall of the inner water-retaining surrounding plate (41) being provided with a water-retaining frame (42), and a second drainage channel (92) communicated with the first drainage channel (91) being formed between the outer wall of the inner water-retaining surrounding plate (41) and a side wall of the water-retaining frame (42).

2. The LED display device according to claim 1, wherein the first mounting chamber (81) is disposed on the display module (20), the inner water-retaining surrounding plate (41) is disposed on the box (10), the outer water-retaining surrounding plate (31) is spaced apart from the box (10) by the first distance, a water-retaining cylinder (43) sheathed on the inner water-retaining surrounding plate (41) is disposed at a circumferential outer edge of the water-retaining frame (42), and a mouth of the water-retaining cylinder (43) faces the box (10).

3. The LED display device according to claim 1, wherein a connecting frame (44) is provided at an end of the inner water-retaining surrounding plate (41) away from the display module (20), the connecting frame (44) is connected to a front surface of the box (10), and an interior of the connecting frame (44) corresponds to the first wire hole (13).

4. The LED display device according to claim 3, wherein a second mounting chamber (82) communicated with the first wire hole (13) is disposed on the front surface of the box (10), the connecting frame (44) is fitted in the second mounting chamber (82), and a waterproof adhesive layer (71) is disposed between a circumferential outer side of the connecting frame (44) and a chamber wall of the second mounting chamber (82).

5. The LED display device according to claim 1, wherein the LED display device further comprises a seal (60) located in the first mounting chamber (81) , the seal (60) being sleeved on a circumferential outer side of the inner water-retaining surrounding plate (41) and located in the circumferential inner side of the outer water-retaining surrounding plate (31), a part of the seal (60) extending into the gap, and a third drainage channel (93) communicating the first drainage channel (91) and the second drainage channel (92) being formed between the seal (60) and the box (10); and the seal (60) having a hardness less than a hardness of the water-retaining frame (42).

6. The LED display device according to claim 5, wherein an end of the inner water-retaining surrounding plate (41) away from the box (10) is provided with a water-retaining flange (45) extending in a circle along a circumferential direction of the inner water-retaining surrounding plate (41), the water-retaining flange (45) is spaced apart from an inner side wall of the seal (60) by a second distance, and the water-retaining flange (45), a part of the outer wall of the inner water-retaining surrounding plate (41) and the water-retaining frame (42) enclose a fourth drainage channel (94) communicated with the second drainage channel (92).

7. The LED display device according to claim 6, wherein the seal (60) comprises a sealing ring portion (61) connected to a rear surface of the display module (20) and a water-retaining ring portion (62) arranged at an end of the sealing ring portion (61) facing the box (10), an inner hole of the sealing ring portion (61) corresponds to the second wire hole (23), a part of the water-retaining ring portion (62) extends into the gap, and an inner part of the water-retaining ring portion (62) shields a circumferential outer edge of the water-retaining frame (42).

8. The LED display device according to claim 7, wherein the first mounting chamber (81) is communicated with the second wire hole (23), the sealing ring portion (61) is fitted in the first mounting chamber (81), and the sealing ring portion (61) comprises an annular plate (612) spaced from the water-retaining ring portion (62) and a connecting surrounding plate (611) for connecting the annular plate (612) and the water-retaining ring portion (62).

9. The LED display device according to claim 7, wherein the LED display device further comprises a bracket (50) supported in the sealing ring portion (61), the bracket (50) being fixed to the rear surface of the display module (20) to sandwich the sealing ring portion (61) between the bracket (50) and the rear surface of the display module (20).

10. The LED display device according to any one of claims 1 to 9, wherein the outer water-retaining surrounding plate (31) is disposed on the rear surface of the display module (20), the first water-retaining structure (30) further comprises a water-retaining groove (32) disposed on the front surface of the box (10) and corresponding to the outer water-retaining surrounding plate (31), the outer water-retaining surrounding plate (31) extends into the water-retaining groove (32), and the first drainage channel (91) is formed between the outer water-retaining surrounding plate (31) and a wall of the water-retaining groove (32) on the box (10).

11. The LED display device according to any one of claims 1 to 9, wherein the box (10) comprises a frame (11) and a power box (12) connected in the frame (11), the first wire hole (13) is disposed on the power box (12), a circuit board is arranged in the power box (12), the circuit board is connected with a first connector, and the first wire hole (13) avoids the first connector; and
the display module (20) comprises a lamp panel module (21) and a rear cover (22) arranged at a rear side of the lamp panel module (21), the rear cover (22) is installed on a front side of the frame (11) through a magnetic attraction structure (72), the second wire hole (23) is disposed on the rear cover (22), the lamp panel module (21) is provided with a second connector being plugged and mated with the first connector, and the second wire hole (23) avoids the second connector.
